(19) Europäisches Patentamt
European Patent Office
Office européen des brevets

(11) **EP 3 454 068 B1**

(12) **EUROPÄISCHE PATENTSCHRIFT**

(45) Veröffentlichungstag und Bekanntmachung des Hinweises auf die Patenterteilung:
**12.02.2020   Patentblatt 2020/07**

(51) Int Cl.:
**G01R 33/30** *(2006.01)*        **G01R 33/34** *(2006.01)*
**G01R 33/3873** *(2006.01)*      **G01R 33/3875** *(2006.01)*

(21) Anmeldenummer: **18191445.8**

(22) Anmeldetag: **29.08.2018**

(54) **BEFESTIGUNGSVORRICHTUNG FÜR EINEN NMR-PROBENKOPF MIT SCHNELLVERSCHLUSS**

FASTENING DEVICE FOR AN NMR SAMPLE HEAD WITH QUICK FASTENER

DISPOSITIF DE FIXATION POUR UNE TÊTE DE SONDE RMN À FERMETURE RAPIDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.09.2017   DE 102017215763**

(43) Veröffentlichungstag der Anmeldung:
**13.03.2019   Patentblatt 2019/11**

(73) Patentinhaber: **Bruker Switzerland AG**
**8117 Fällanden (CH)**

(72) Erfinder:
• **Meister, Roger**
  **8132 Hinteregg (CH)**

• **Mayer, Markus**
  **8625 Gossau (CH)**
• **Krahn, Alexander**
  **76137 Karlsruhe (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**US-A1- 2009 015 259**

EP 3 454 068 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft eine Befestigungsvorrichtung zum lösbaren Befestigen eines NMR-Probenkopfs an einem NMR-Magneten, dessen Hauptachse parallel zu einer z-Richtung verläuft, mit einem scheibenförmigen Einsatzteil, welches dazu vorgesehen ist, zur Befestigung des NMR-Probenkopfs von unten her gegen ein an der Unterseite des NMR-Magneten angeordnetes, mit dem Magnet starr verbundenes Haltesystem, das Teil der Befestigungsvorrichtung ist, geschoben zu werden, wobei durch eine Drehung des Einsatzteils um seine Scheibenachse eine feste mechanische Verbindung zwischen Probenkopf und Einsatzteil einerseits und zwischen Einsatzteil und Haltesystem andererseits hergestellt werden kann, nachdem der Probenkopf gegen die dem Haltesystem abgewandte Unterseite des Einsatzteils bis zum Kontakt des oberen Ende des Probenkopfs mit dem oberen Ende des Haltesystems geschoben wurde, und wobei das scheibenförmige Einsatzteil so ausgebildet ist, dass mit Hilfe mindestens eines Federelements zusätzlich zu einem Formschluss auch eine Kraft-variable Verbindung zwischen dem Probenkopf und dem Haltesystem aufgebaut werden kann.

Eine solche Anordnung ist bekannt aus der Firmenbroschüre "Manual Probes. User Manual Version 003" Bruker BioSpin AG aus dem September 2009  (=Referenz [1]), insbesondere aus den Kapiteln 5.2 und 5.8 dieser Druckschrift.

Hintergrund der Erfindung

Zur Analyse von Probenzusammensetzungen oder zur Strukturbestimmung von Stoffen in Proben werden NMR-Verfahren eingesetzt. Die NMR-Spektroskopie ist ein leistungsfähiges Verfahren der instrumentellen Analytik. Bei diesen NMR-Verfahren ist die Probe einem starken statischen Magnetfeld $B_0$ in einer z-Richtung ausgesetzt. Dabei kommt es zu einer Wechselwirkung mit den Kernspins des Probenmaterials, insbesondere zur Ausrichtung von Kernspins in der Messsubstanz. Sodann werden dazu orthogonale hochfrequente elektromagnetische Impulse in x- oder y-Richtung in die Probe eingestrahlt. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe integral über einen gewissen räumlichen Bereich erhalten werden. Insbesondere kann aus der Lage und Intensität von NMR-Linien auf die chemische Zusammensetzung sowie die chemischen Bindungsverhältnisse in der Probe geschlossen werden (siehe beispielsweise DE 10 2013 204 131 B3 = Referenz [2]).

Die Messprobe besteht in der Regel aus einem zylindrischen Probenröhrchen mit üblicherweise kreisrundem, ovalem oder rechteckigem Querschnitt, welches die feste oder flüssige Messsubstanz enthält. Das Probenröhrchen ist mindestens auf der Seite verschlossen, mit der es zuerst in den Probenkopf eindringt, und befindet sich typischerweise in einem Spinner. Probenröhrchen und Spinner werden mit Hilfe eines Transportsystems von außerhalb des Magneten in den Probenkopf transportiert. Im Folgenden wird davon ausgegangen, dass sich die Einführungsöffnung oben am Probenkopf befindet und das Probenröhrchen von oben in den Probenkopf eingeführt wird. Es ist jedoch auch denkbar, das Probenröhrchen von unten in eine dafür vorgesehene Öffnung in den Probenkopf einzuführen. Dieser Fall ist analog zum oben genannten und wird aus Übersichtlichkeitsgründen nicht explizit beschrieben. Wenn sich das Probenröhrchen in der Messposition befindet, dann befindet sich der Spinner innerhalb der Turbine. Die Turbine ermöglicht eine Rotation des Probenröhrchens (siehe beispielsweise DE 10 2013 212 312 B4 = Referenz [3]).

Die derzeit erhältlichen sogenannten "Standard Bore" Probenköpfe werden mit Hilfe von zwei Schrauben an einem SHIM-System befestigt. Dies ist für den Anwender sehr umständlich, da er zum einen für die Montage des Probenkopfes unter den Magneten kriechen und dort in kniender Körperhaltung arbeiten muss. Zum anderen sind die relativ kleinen Schrauben aufgrund der Montageposition des Probenkopfs am Magneten sehr umständlich und normalerweise nur mit einem Spezialschraubenzieher anzuziehen.

Wenn die Befestigungsschrauben angezogen sind, ist die Befestigung fix und kann sich nicht mehr an spätere Längenänderungen anpassen, die zum Beispiel durch Temperaturänderungen hervorgerufen werden können. Diese Längenänderungen können dann ein mechanisches Spiel oder eine nicht zulässige axiale Spannung zwischen Probenkopf und Haltesystem hervorrufen.

Die heutigen sogenannten "Wide Bore" Probenköpfe werden mit einem -an sich bereits bekannten- Schnellverschluss an das Haltesystem montiert. Durch die konstruktiv bedingte Kulissenform des Spannsystems wird beim Bedienen des Spannrings bereits am Anfang des Montagevorgangs die maximale Kraft auf den Probenkopf gebracht. Nach dem Überwinden dieser maximalen Kraft entspannt sich das System wieder und der Probenkopf ist mit einer nicht definierten Kraft bis hin zu einem möglicherweise nicht mehr tolerierbaren Spiel im SHIM-System der NMR-Apparatur montiert.

Um diese Schwierigkeiten zu vermeiden, müssen derzeit bei jedem Probenkopf die Halteelemente individuell auf das jeweilige SHIM-System eingestellt werden. Die eingestellte Kraft kann dabei aber nicht kontrolliert werden. Es kann lediglich geprüft werden, ob ein mechanisches Spiel (tolerabel oder nicht mehr tolerierbar) vorhanden ist oder eben nicht.

Diese Umstände machten es bisher unmöglich, den bereits von den "Wide Bore" Probenköpfen bekannten Schnellverschluss auch zur Montage von "Standard Bore" Probenköpfen einzusetzen, da es bei den "Standard Bore" Probenköpfen sehr wichtig ist, dass überhaupt kein Spiel respektive keine allzu hohe Kraft zwischen Probenkopf und SHIM-System vorhanden sind.

Dazu kommt, dass beim bekannten Schnellverschluss von "Wide Bore" Probenköpfen keine Verriegelung gegen ein unbeabsichtigtes Öffnen vorhanden ist. Dies ist jedoch aufgrund von Sicherheitsbetrachtungen sowie daraus resultierenden Marketingüberlegungen bei den "Standard Bore" Probenköpfen eine feste Anforderung.

## Aufgabe der Erfindung

Der vorliegenden Erfindung liegt demgegenüber die Aufgabe zugrunde, eine Befestigungsvorrichtung der eingangs definierten Art mit möglichst einfachen technischen Maßnahmen so zu modifizieren, dass die oben aufgezählten Nachteile vollständig oder zumindest weitestgehend vermieden werden, ohne damit eine Minderung der Qualität der NMR-Messungen hervorzurufen, wobei der NMR-Probenkopf besonders kompakt bleiben soll und die Materialkosten sowie der Fertigungsaufwand reduziert werden.

Eine weitere Aufgabe der vorliegenden Erfindung besteht darin, ein schnelles Wechseln des Probenkopfes zu ermöglichen, ohne dadurch eine erheblich verkürzte Lebensdauer des Probenkopfes zu riskieren.

## Kurze Beschreibung der Erfindung

Diese komplexe Aufgabe wird auf ebenso überraschend einfache wie wirkungsvolle Weise dadurch gelöst, dass bei einer gattungsgemäßen Befestigungsvorrichtung mit den eingangs definierten Merkmalen der Probenkopf am Einsatzteil mittels mehrerer jeweils einstückiger starrer Halteelemente von jeweils unabänderlicher fester Länge, die Teil der Befestigungseinrichtung sind, befestigbar ist, dass das Federelement bzw. die Federelemente des Einsatzteils sowie die Halteelemente geometrisch derart ausgestaltet sind, dass in einem ersten, geöffneten Zustand zwischen dem Einsatzteil und den Halteelementen eine Verbindung mit mechanischem Spiel von 0,5mm bis 5mm vorhanden ist, wobei das Federelement entspannt ist, und dass in einem zweiten, geschlossenen Zustand zwischen dem Einsatzteil und den Halteelementen eine Verbindung ohne mechanisches Spiel vorhanden ist, wobei das Federelement bzw. die Federelemente unter mechanischer Spannung steht/stehen.

Die erfindungsgemäße Befestigungsvorrichtung weist also im Gegensatz zur bisher üblichen Ausführung sowohl für "Wide Bore" Probenköpfe als auch für den "Standard Bore" Probenköpfe im montierten Zustand immer eine, in einem bestimmten Bereich definierte, Kraft auf, die zwischen dem Probenkopf und dem Haltesystem anliegt. Die Federelemente sind erfindungsgemäß so gestaltet, dass die Haltekraft bei der Betätigung des Halteelements kontinuierlich ansteigt und in der Endlage ihr Maximum erreicht. Durch diese neue Ausgestaltung des -an sich bereits bekannten- Federelements (bzw. der Federelemente) ist es jetzt nicht mehr möglich, dass in der Montage-Endlage ein Spiel zwischen Probenkopf und dem NMR-Magnetsystem oder einem SHIM System entstehen kann.

Gerade aufgrund der durch die Erfindung eröffneten Möglichkeiten eines solchen Schnellverschlusses ist es nicht mehr möglich, dass der Anwender Fehlmanipulationen bei der Montage des NRM-Probenkopfs am Haltesystem, wie zum Beispiel beim Einstellen der Haltelemente bei einem "Wide Bore" System, in Kauf nehmen muss. Da bei dem Schnellwechselsystem gemäß der vorliegenden Erfindung die Längentoleranzen der beteiligten Komponenten mittels Federelementen aufgenommen werden, kann es nicht mehr vorkommen, dass sich das System in einem mechanisch undefinierten Zustand befindet.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetspulensystems liegen, sondern gegebenenfalls auch "rechts" oder "links" neben demselben. Jedenfalls spielt die Schwerkraft bei der Wirkungsweise der vorliegenden Erfindung eine untergeordnete Rolle.

## Bevorzugte Ausführungsformen der Erfindung

Je nach speziellem Einsatzzweck können Ausführungsformen der erfindungsgemäßen Befestigungsvorrichtung von Nutzen sein, bei denen der NMR-Probenkopf am Einsatzteil mittels genau zweier gegenüberliegender Halteelemente befestigbar ist, die insbesondere als simple Haltebolzen ausgeführt sein können. Diese Ausführungsformen sind äußerst einfach aufgebaut und fördern eine schnelle, gleichwohl sichere Montage beziehungsweise Demontage des Probenkopfes am oder vom NMR-Magneten.

Besonders bevorzugt sind Ausführungsformen der erfindungsgemäßen Befestigungsvorrichtung, bei welchen das Federelement so gestaltet ist, dass die Haltekraft bei der Betätigung der Halteelemente kontinuierlich ansteigt und in der Endlage im zweiten, geschlossenen Zustand ihr Maximum erreicht.

Dies ist gegenüber dem "Wide Bore" System ein großer Vorteil, da bei diesem heute bei der Betätigung zuerst die Maximalkraft überwunden werden muss und in der Endposition eine undefinierte Haltekraft bis hin zu mechanischem Spiel am System vorhanden ist.

Des Weiteren sind Ausführungsformen von großem Vorteil, die sich dadurch auszeichnen, dass das Federelement bzw. die Federelemente so ausgestaltet ist/ sind, dass eine spielfreie Verbindung zwischen dem Probenkopf und dem Haltesystem schon entsteht, bevor das Einsatzteil bei einer Drehung in Verschließrichtung in seiner Endposition im zweiten, geschlossenen Zustand angelangt ist.

Bei weiteren bevorzugten Ausführungsformen der Erfindung ist das scheibenförmige Einsatzteil als Schnellmontagevorrichtung ausgebildet, vorzugsweise als Bajonettverschluss, der insbesondere um die Scheibenachse parallel zur z-Richtung drehbar ist. Ein wesentlicher Vorteil einer solchen Anordnung besteht darin, dass man einen sehr kurzen Betätigungsweg der Montage des Probenkopfs am Haltesystem hat.

Ganz besonders bevorzugt sind auch Ausführungsformen der erfindungsgemäßen Befestigungsvorrichtung, bei denen eine Verriegelungsvorrichtung gegen unbeabsichtigtes Lösen einer Halterung vorhanden ist. Durch einen derartigen Verriegelungsmechanismus ist das neue Befestigungssystem stets geschützt gegen unbeabsichtigtes Öffnen.

Weitere bevorzugte Ausführungsformen der erfindungsgemäßen Befestigungsvorrichtung sind dadurch gekennzeichnet, dass der Probenkopf am Einsatzteil mittels mehrerer, vorzugsweise zweier gegenüberliegender, Halteelemente, insbesondere Haltebolzen, befestigbar ist, die auf einem Lochkreis zwischen 10cm und 15cm angeordnet sind, und dass die Halteelemente eine maximale radiale Längenausdehnung in der Scheibenebene des Einsatzteils zwischen 5mm und 10mm, vorzugsweise etwa 8mm, aufweisen. Das hat den Vorteil, dass mit diesen Dimensionen die Befestigungsvorrichtung für SB und WB funktioniert, aber der Platzbedarf minimal gehalten werden kann.

Alternativ oder ergänzend zeichnen sich weitere vorteilhafte Ausführungsformen der Erfindung dadurch aus, dass die Bauhöhe der kompletten Befestigungsvorrichtung parallel zur Scheibenachse des Einsatzteils zwischen 7mm und 15mm, vorzugsweise etwa 10mm, beträgt. Der Vorteil ist, dass durch die geringe Bauhöhe der Befestigungsvorrichtung der zur Verfügung stehende Platz für den Probenkopf maximal bleibt. Die minimale Bauhöhe für die Befestigungsvorrichtung ist gegeben durch den gewünschten Federweg. Dieser Federweg geht direkt in die Bauhöhe der Befestigungsvorrichtung ein.

Bei anderen vorteilhaften Ausführungsformen der Erfindung umfasst das scheibenförmige Einsatzteil eine Federkulisse aus nichtmagnetischem Material, vorzugsweise aus Feder-Bronze. Von Vorteil ist, dass keine zusätzlichen Kräfte, die aus dem Zusammenspiel von NMR-Magnet und magnetischen Materialien hervorgerufen werden, auf die Mechanik wirken. Zusätzlich kann ein magnetisches Material zu Feldstörungen führen, welche dann die NMR-Messung beeinflussen können.

Bei vorteilhaften Weiterbildungen dieser Ausführungsformen ist die Federkulisse einteilig aufgebaut. Dies ermöglicht auf besonders einfache Weise, dass erstens eine kostengünstige Fertigung gemacht werden kann (keine Montagearbeit) und zum anderen der Bauraum optimaler ausgenutzt werden kann. Bei einem einteiligen Element braucht man keine Verbindungspartien, welche Bauraum benötigen. Dieser Bauraum kann für Federstärke und Federlänge genutzt werden. Dies wiederum ergibt mehr Federweg.

Eine besonders bevorzugte Klasse von Ausführungsformen der Erfindung ist dadurch gekennzeichnet, dass an der Magnet-abgewandten Unterseite des Haltesystems ein Halteabschnitt starr befestigt ist, an welchem das Einsatzteil reversibel montierbar ist. Der Vorteil ist, dass der Schnellverschluss an bereits installierte NMR-Magnete respektive Haltesysteme nachgerüstet werden kann. Bei vorteilhaften Weiterbildungen dieser Klasse von Ausführungsformen umgibt der Halteabschnitt das Einsatzteil im montierten Zustand radial Gehäuse-artig. Der Vorteil ist, dass das Einsatzteil für eine Drehbewegung sauber geführt ist, und dass das Einsatzteil im Gehäuse geschützt ist.

Besonders vorteilhafte Varianten dieser Weiterbildungen sind dadurch gekennzeichnet, dass zwischen dem Halteabschnitt und dem Einsatzteil eine Gleitlagerung vorgesehen ist. Der Vorteil ist, dass die Bedienkraft minimal ist. Die Gleitlagerung ist gegenüber der Kugellagerung vom WB viel einfacher für die Montage.

Diese Varianten lassen sich schließlich noch dadurch weiter verbessern, dass die Materialien der Gleitpartner in der Gleitlagerung so gewählt sind, dass die Bedienkraft und der Abrieb minimiert sind, wobei vorzugsweise PET-C und Feder-Bronze als Gleitpartner verwendet werden. Der Vorteil ist, dass durch diese Materialwahl direkt die Hauptkomponenten (Einsatzteil und Halteelement) als Gleitpartner verwendet werden können.

Ganz besonders bevorzugt ist eine Klasse von Ausführungsformen, bei denen die Kombination aus Federelement/en, der Länge des Probenkopfs und der Länge des Haltesystems so gestaltet ist, dass bei Betätigung des Einsatzteils ein Federweg $f \geq 2mm$ ausgelöst wird. Der Vorteil ist, dass alle mechanischen Fertigungstoleranzen aufgenommen werden können und damit ein Spiel absolut sicher vermieden wird.

In der Praxis bewähren sich auch Ausführungsformen der erfindungsgemäßen Befestigungsvorrichtung, bei denen das Haltesystem als Shimsystem zur Feldformung des homogenen Magnetfelds in einem NMR-Spektrometer ausgebildet ist.

In den Rahmen der vorliegenden Erfindung fällt auch eine NMR-Messanordnung mit einer erfindungsgemäßen Befestigungsvorrichtung der oben beschriebenen Art, die ein NMR-Magnetsystem und gegebenenfalls auch ein Shimsystem sowie einen Kryostaten umfassen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1a    eine schematische räumliche Seitenansicht von schräg oben auf eine erste Ausführungsform der erfindungsgemäßen Befestigungsvorrichtung;

Fig. 1b    eine schematische Seitenansicht auf diese Ausführungsform in vertikaler Schnittdarstellung;

Fig. 2    eine schematische vertikale Schnittansicht auf ein NMR-Spektrometer mit erfindungsgemäßer Befestigungsvorrichtung; und

Fig. 3    einen schematischen Vertikalschnitt durch einen am Haltesystem montierten Probenkopf, und zwar in der linken Bildhälfte (O) im ersten, geöffneten Zustand zwischen dem Einsatzteil und den Halteelementen, in der rechten Bildhälfte (G) im zweiten, geschlossenen Zustand.

Generell befasst sich die Erfindung mit einer modifizierten Befestigungsvorrichtung zum lösbaren Befestigen eines **NMR-Probenkopfes 1** an einem **NMR-Magneten 2**, dessen Hauptachse parallel zu einer **z-Richtung** verläuft, mit einem scheibenförmigen **Einsatzteil 3**, welches zur Befestigung des NMR-Probenkopfs 1 von unten her gegen ein an der Unterseite des NMR-Magneten 2 angeordnetes, mit dem Magneten starr verbundenes **Haltesystem 4** geschoben wird, wobei dann gegen die dem Haltesystem 4 abgewandte Unterseite des Einsatzteils 3 der NMR-Probenkopf 1 bis zum Kontakt des oberen Ende des Probenkopfs 1 mit dem oberen Ende des Haltesystems 4 geschoben wird und anschließend durch eine Drehung des Einsatzteils 3 um seine Scheibenachse parallel zur z-Richtung eine feste mechanische Verbindung zwischen Probenkopf 1 und Einsatzteil 3 einerseits und zwischen Einsatzteil 3 und Haltesystem 4 andererseits hergestellt wird, und wobei das scheibenförmige Einsatzteil 3 so ausgebildet ist, dass mit Hilfe eines **Federelements 8** zusätzlich zu einem Formschluss auch eine Kraft-variable Verbindung zwischen dem Probenkopf 1 und dem Haltesystem 4 aufgebaut werden kann.

Die vorliegende Erfindung ist demgegenüber dadurch charakterisiert, dass der Probenkopf 1 am Einsatzteil 3 mittels mehrerer, vorzugsweise genau zweier gegenüberliegender, **Halteelemente 6** befestigbar ist, die insbesondere als simple Haltebolzen ausgeführt sein können. Erfindungsgemäß sind die Halteelemente 6 einstückig und starr aufgebaut und daher von jeweils unabänderlicher fester Länge.

Erfindungsgemäß sind zudem das Federelement 8 des Einsatzteils 3 sowie die Halteelemente 6 geometrisch derart gestaltet, dass in einem ersten, geöffneten Zustand zwischen dem Einsatzteil 3 und den Halteelementen 6 eine Verbindung mit mechanischem Spiel von 0,5mm bis 5mm vorhanden ist, wobei das Federelement 8 entspannt ist, und dass in einem zweiten, geschlossenen Zustand zwischen dem Einsatzteil 3 und den Halteelementen 6 eine Verbindung ohne mechanisches Spiel vorhanden ist, wobei das Federelement 8 unter mechanischer Spannung steht.

In der Regel wird die Haltekraft bei der Betätigung der Halteelemente 6 kontinuierlich ansteigen und in der Endlage im zweiten, geschlossenen Zustand ihr Maximum erreichen.

Eine spielfreie Verbindung zwischen dem Probenkopf 1 und dem Haltesystem 4 kann auch schon entstehen, bevor das Einsatzteil 3 bei einer Drehung in Verschließrichtung in seiner Endposition im zweiten, geschlossenen Zustand angelangt ist.

Vorzugsweise ist das scheibenförmige Einsatzteil 3 als Schnellmontagevorrichtung ausgebildet, insbesondere als Bajonettverschluss, der um die Scheibenachse parallel zur z-Richtung drehbar ist.

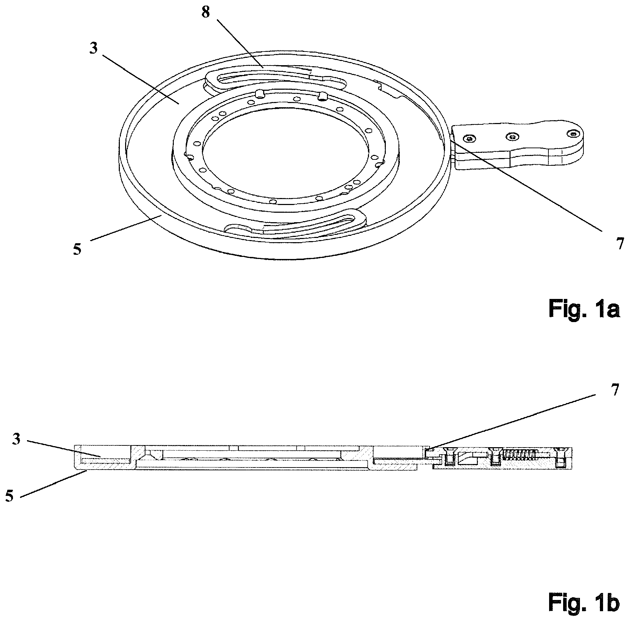

Bei der in den **Figuren 1a und 1b** dargestellten Ausführungsform der erfindungsgemäßen Befestigungsvorrichtung ist eine **Verriegelungsvorrichtung 7** gegen unbeabsichtigtes Lösen der Halterung vorhanden.

Wie in den Figuren 1a und 1b weiter zu erkennen ist, kann die Federkulisse des scheibenförmigen Einsatzteils 3 einteilig aufgebaut sein. In der Regel wird sie aus nichtmagnetischem Material, vorzugsweise aus Feder-Bronze wie etwa Berylco®, hergestellt sein.

Schließlich zeigen die Figuren 1a und 1b eine besonders bevorzugte Ausführungsform, bei welcher an der Magnet-abgewandten Unterseite des Haltesystems 4 ein **Halteabschnitt 5** starr befestigt ist, an welchem das Einsatzteil 3 reversibel montierbar ist. Der Halteabschnitt 5 umgibt das Einsatzteil 3 im montierten Zustand radial und wirkt dabei wie ein schützendes Gehäuse.

Bevorzugt kann zwischen dem Halteabschnitt 5 und dem Einsatzteil 3 eine -in der Zeichnung nicht eigens dargestellte- Gleitlagerung vorgesehen sein. Die Materialien der Gleitpartner in der Gleitlagerung werden dann so gewählt, dass die Bedienkraft und der Abrieb minimiert sind, wobei vorzugsweise PET-C und Berylco® als Gleitpartner verwendet werden.

In der Regel wird das scheibenförmige Einsatzteil 3 derart ausgebildet sein, dass mit Hilfe eines Federelements 8 zusätzlich zu einem Formschluss auch eine Kraft-variable Verbindung zwischen dem Probenkopf 1 und dem Haltesystem 4 aufgebaut werden kann, wobei das Federelement 8 so gestaltet ist, dass bei seiner Betätigung ein Federweg $f \geq 2mm$ ausgelöst wird.

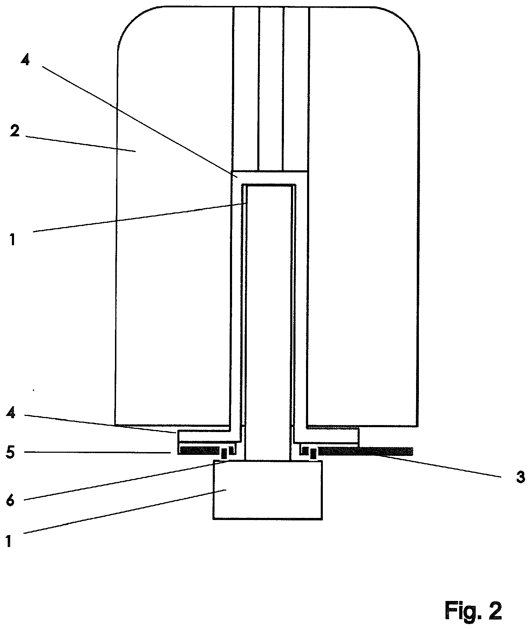

**Fig. 2** zeigt schematisch, wie das erfindungsgemäße Befestigungssystem eine schnelle Montage beziehungsweise Demontage eines NMR-Probenkopfes 1 an einem NMR-Magneten 2 ermöglicht. Dazu wird zunächst das scheibenförmige Einsatzteil 3, an welchem der NMR-Probenkopf 1 mittels der Halteelemente 6 befestigt ist, von unten her gegen die Unterseite eines im NMR-Magneten 2 angeordneten, mit dem Magneten 2 starr verbundenen Haltesystems 4 geschoben. Anschließend wird durch eine Drehung des Einsatzteils 3 um seine Scheibenachse eine feste mechanische Verbindung zwischen Probenkopf 1 und Einsatzteil 3 einerseits und zwischen Einsatzteil 3 und Haltesystem 4 andererseits hergestellt.

Das Haltesystem 4 kann übrigens auch als Shimsystem zur Feldformung des homogenen Magnetfelds in einem NMR-Spektrometer ausgebildet sein.

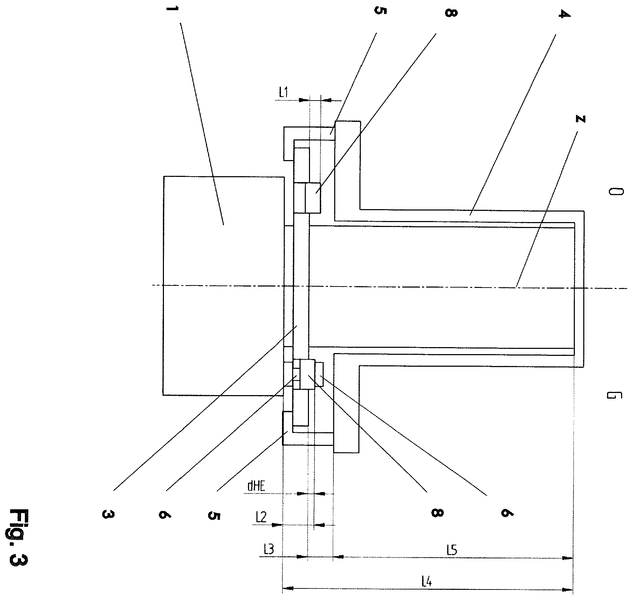

**Fig. 3** schließlich verdeutlicht in einem schematischen Vertikalschnitt durch einen am Haltesystem 4 montierten Probenkopf 1, wie sich die relativen Abstände der beteiligten Systemkomponenten in den beiden hervorgehobenen Montagezuständen erfindungsgemäß verhalten, und zwar in der linken Bildhälfte (gekennzeichnet mit "O") im ersten, geöffneten Zustand zwischen dem Einsatzteil 3 und den Halteelementen 6 und in der rechten Bildhälfte (gekennzeichnet mit "G") im zweiten, geschlossenen Zustand:
Unter den geometrischen Verhältnissen

$$(L5\_min + L3\_min) - (L4\_max - L2\_min) = dHE\_min$$

$$(L5\_max + L3\_max) - (L4\_min - L2\_max) = dHE\_max$$

müssen die nachfolgenden geometrischen Bedingungen erfüllt sein:

Geometrische Bedingung für Spielfreiheit:

$$L1 > dHE\_max$$

Geometrische Bedingung für Montierbarkeit:

$$dHE\_max > 0$$

Dabei bedeuten:

L1      ungespannte Höhe des Federelements 8
L2      Höhe der Halteelemente 6
L3      Höhe des Einsatzteils 3
L4      Höhe der NMR-Probe
L5      Höhe des Haltesystems 5
dHE      Spiel zwischen dem Einsatzteil 3 und den Halteelementen 6

**Bezugszeichenliste:**

1  NMR-Probenkopf
2  NMR-Magnet
3  Einsatzteil
4  Haltesystem
5  Halteabschnitt
6  Halteelemente
7  Verriegelungsvorrichtung
8  Federelement

**Referenzliste:**

Für die Beurteilung der Patentfähigkeit in Betracht gezogene Publikationen:

[1] Firmenbroschüre "Manual Probes. User Manual Version 003" Bruker BioSpin AG aus dem September 2009
[2] DE 10 2013 204 131 B3
[3] DE 10 2013 212 312 B4

**Patentansprüche**

1. Befestigungsvorrichtung zum lösbaren Befestigen eines NMR-Probenkopfs (1) an einem NMR-Magneten (2), dessen Hauptachse parallel zu einer z-Richtung verläuft, mit einem scheibenförmigen Einsatzteil (3), welches dazu vorgesehen ist, zur Befestigung des NMR-Probenkopfs (1) von unten her gegen ein an der Unterseite des NMR-Magneten (2) angeordnetes, mit dem Magneten (2) starr verbundenes Haltesystem (4), das Teil der Befestigungsvorrichtung ist, geschoben zu werden, wobei durch eine Drehung des Einsatzteils (3) um seine Scheibenachse eine feste mechanische Verbindung zwischen Probenkopf (1) und Einsatzteil (3) einerseits und zwischen Einsatzteil (3) und Haltesystem (4) andererseits hergestellt werden kann, nachdem der NMR-Probenkopf (1) gegen die dem Haltesystem (4) abgewandte Unterseite des Einsatzteils (3) bis zum Kontakt des oberen Endes des Probenkopfs (1) mit dem oberen Ende des Haltesystems (4) geschoben wurde, und wobei das scheibenförmige Einsatzteil (3) so ausgebildet ist, dass mit Hilfe mindestens eines Federelements (8) zusätzlich zu einem Formschluss auch eine Kraft-variable Verbindung zwischen dem Probenkopf (1) und dem Haltesystem (4) aufgebaut werden kann,
**dadurch gekennzeichnet,**
**dass** der Probenkopf (1) am Einsatzteil (3) mittels mehrerer jeweils einstückiger starrer Halteelemente (6) von jeweils unabänderlicher fester Länge, die Teil der Befestigungsvorrichtung sind, befestigbar ist, dass das Federelement bzw. die Federelemente (8) des Einsatzteils (3) sowie die Halteelemente (6) geometrisch derart ausgestaltet sind, dass in einem ersten, geöffneten Zustand zwischen dem Einsatzteil (3) und den Halteelementen (6) eine Verbindung mit mechanischem Spiel von 0,5mm bis 5mm vorhanden ist, wobei das Federelement (8) bzw. die Federelemente (8) entspannt ist/sind, und dass in einem zweiten, geschlossenen Zustand zwischen dem Einsatzteil (3) und den Halteelementen (6) eine Verbindung ohne mechanisches Spiel vorhanden ist, wobei das Federelement (8) bzw. die Federelemente (8) unter mechanischer Spannung steht/stehen.

2. Befestigungsvorrichtung nach Anspruch 1, **dadurch gekennzeichnet, dass** das Federelement (8) bzw. die Federelemente (8) so ausgestaltet ist/sind, dass die Haltekraft bei der Betätigung der Halteelemente (6) kontinuierlich ansteigt und in der Endlage im zweiten, geschlossenen Zustand ihr Maximum erreicht.

3. Befestigungsvorrichtung nach Anspruch 1 oder 2, **dadurch gekennzeichnet, dass** eine spielfreie Verbindung zwischen dem Probenkopf (1) und dem Haltesystem (4) schon entsteht, bevor das Einsatzteil (3) bei einer Drehung in Verschließrichtung in seiner Endposition im zweiten, geschlossenen Zustand angelangt ist.

4. Befestigungsvorrichtung nach einem der vorhergehenden Ansprüche, **dadurch gekennzeichnet, dass** das scheibenförmige Einsatzteil (3) als Schnellmontagevorrichtung ausgebildet ist, vorzugsweise als Bajonettverschluss, der insbesondere um die Scheibenachse parallel zur z-Richtung drehbar ist.

5. Befestigungsvorrichtung nach einem der vorhergehenden Ansprüche, **dadurch gekennzeichnet, dass** eine Verriegelungsvorrichtung (7) gegen unbeabsichtigtes Lösen einer Halterung vorhanden ist.

6. Befestigungsvorrichtung nach einem der vorhergehenden Ansprüche, **dadurch gekennzeichnet, dass** der Probenkopf (1) am Einsatzteil (3) mittels mehrerer, vorzugsweise zweier gegenüberliegender, Halteelemente (6), insbesondere Haltebolzen, befestigbar ist, die auf einem Lochkreis um die Scheibenachse mit einem Durchmesser zwischen 10cm und 15cm angeordnet sind, und dass die Halteelemente (6) eine maximale radiale Längenausdehnung in der Scheibenebene des Einsatzteils (3) zwischen 5mm und 10mm, vorzugsweise etwa 8mm, aufweisen.

7. Befestigungsvorrichtung nach einem der vorhergehenden Ansprüche, **dadurch gekennzeichnet, dass** die Bauhöhe der kompletten Befestigungsvorrichtung parallel zur Scheibenachse des Einsatzteils (3) zwischen 7mm und 15mm, vorzugsweise etwa 10mm, beträgt.

8. Befestigungsvorrichtung nach einem der vorhergehenden Ansprüche, **dadurch gekennzeichnet, dass** das scheibenförmige Einsatzteil (3) eine Federkulisse aus nichtmagnetischem Material, vorzugsweise aus Feder-Bronze, umfasst.

9. Befestigungsvorrichtung nach Anspruch 8, **dadurch gekennzeichnet, dass** die Federkulisse einteilig aufgebaut ist.

10. Befestigungsvorrichtung nach einem der vorhergehenden Ansprüche, **dadurch gekennzeichnet, dass** an der Magnet-abgewandten Unterseite des Haltesystems (4) ein Halteabschnitt (5) starr befestigt ist, an welchem das Einsatzteil (3) reversibel montierbar ist.

11. Befestigungsvorrichtung nach Anspruch 10, **dadurch gekennzeichnet, dass** der Halteabschnitt (5) das Einsatzteil (3) im montierten Zustand radial Gehäuse-artig umgibt.

12. Befestigungsvorrichtung nach Anspruch 10 oder 11, **dadurch gekennzeichnet, dass** zwischen dem Halteabschnitt (5) und dem Einsatzteil (3) eine Gleitlagerung vorgesehen ist.

13. Befestigungsvorrichtung nach Anspruch 12, **dadurch gekennzeichnet, dass** die Materialien der Gleitpartner in der Gleitlagerung so gewählt sind, dass die Bedienkraft und der Abrieb minimiert sind, wobei vorzugsweise PET-C und Feder-Bronze als Gleitpartner verwendet werden.

14. Befestigungsvorrichtung nach einem der vorhergehenden Ansprüche, **dadurch gekennzeichnet, dass** die Kombination aus Federelement/en (8), der Länge des Probenkopfs (1) und der Länge des Haltesystems (4) so gestaltet ist, dass bei Betätigung des Einsatzteils (3) ein Federweg $f \geq 2mm$ ausgelöst wird.

15. Befestigungsvorrichtung nach einem der vorhergehenden Ansprüche, **dadurch gekennzeichnet, dass** das Haltesystem (4) als Shimsystem zur Feldformung des homogenen Magnetfelds in einem NMR-Spektrometer ausgebildet ist.

**Claims**

1. Fastening device for releasably fastening an NMR probe head (1) to an NMR magnet (2), the main axis of which extends in parallel with a z-direction, comprising a discoid insert (3) which is designed to be pushed from below against a retention system (4) that is arranged on the lower face of the NMR magnet (2), is rigidly connected to the magnet (2) and is part of the fastening device in order to fasten the NMR probe head (1), wherein by means of rotating the insert (3) about its disc axis, a rigid mechanical connection can be established between the probe head (1) and the insert (3) and between the insert (3) and the retention system (4) after the NMR probe head (1) has been pushed against the lower face of the insert (3) that is remote from the retention system (4) until the upper end of the probe head (1) comes into contact with the upper end of the retention system (4), and wherein the discoid insert (3) is designed such that, in addition to a form-fitting connection, a variable-force connection can also be established between the probe head (1) and the retention system (4), using at least one spring element (8),
**characterized in that**
the probe head (1) is fastenable to the insert (3) by means of a plurality of rigid retaining elements (6) that are each integral, are of an invariable fixed length in each case and are part of the fastening device, the spring element or the spring elements (8) of the insert (3), and the retaining elements (6) are designed geometrically such that in a first, opened state a connection having mechanical backlash of from 0.5 mm to 5 mm exists between the insert (3) and the retaining elements (6), the spring element (8) or the spring elements (8) being relaxed, and such that, in a second, closed state a connection without mechanical backlash exists between the insert (3) and the retaining elements (6), the spring element (8) or spring elements (8) being subject to mechanical tension.

2. Fastening device according to claim 1, **characterized in that** the spring element (8) or the spring elements (8) is/are designed such that the retaining force increases continuously when the retaining element (6) is actuated and reaches its maximum in the end position, in the second, closed state.

3. Fastening device according to either claim 1 or claim 2, **characterized in that** a zero-backlash connection already forms between the probe head (1) and the retention system (4) before the insert (3) has reached its end position, in the second, closed state, when rotated in the closure direction.

4. Fastening device according to any of the preceding claims, **characterized in that** the discoid insert (3) is designed as a quick-mounting device, preferably as a bayonet connector, which is in particular rotatable about the disc axis, in parallel with the z-direction.

5. Fastening device according to any of the preceding claims, **characterized in that** a locking device (7) is provided for locking against inadvertent release of a retainer.

6. Fastening device according to any of the preceding claims, **characterized in that** the probe head (1) is fastenable to the insert (3) by means of a plurality of, preferably two, opposing retaining elements (6), in particular retaining bolts, which are arranged on a pitch circle about the disc axis having a diameter of between 10 cm and 15 cm, and **in that** the retaining elements (6) have a maximum radial linear extent in the disc plane of the insert (3) of between 5 mm and 10 mm, preferably approximately 8 mm.

7. Fastening device according to any of the preceding claims, **characterized in that** the overall height of the complete fastening device in parallel with the disc plane of the insert (3) is between 7 mm and 15 mm, preferably approximately 10 mm.

8. Fastening device according to any of the preceding claims, **characterized in that** the discoid insert (3) comprises a spring link made of non-magnetic material, preferably phosphor bronze.

9. Fastening device according to claim 8, **characterized in that** the spring link is integral.

10. Fastening device according to any of the preceding claims, **characterized in that** a retaining portion (5), on which the insert (3) is reversibly mountable, is rigidly fastened to the lower face of the retention system (4) that is remote from the magnet.

11. Fastening device according to claim 10, **characterized in that** the retaining portion (5) radially surrounds the insert (3), in the manner of a housing, in the mounted state.

12. Fastening device according to either claim 10 or claim 11, **characterized in that** a sliding bearing is provided between the retaining portion (5) and the insert (3).

13. Fastening device according to claim 12, **characterized in that** the materials of the sliding partners in the sliding bearing are selected such that the operating force and the wear are minimized, wherein preferably PET-C and phosphor bronze are used as sliding partners.

14. Fastening device according to any of the preceding claims, **characterized in that** the combination of spring element(s) (8), the length of the probe head (1) and the length of the retention system (4) is designed such that a spring excursion f ≥ 2 mm is triggered when the insert (3) is actuated.

15. Fastening device according to any of the preceding claims, **characterized in that** the retention system (4) is designed as a shim system for field shaping of the homogenous magnetic field in an NMR spectrometer.

**Revendications**

1. Dispositif de fixation pour fixer de manière amovible une tête de sonde RMN (1) à un aimant RMN (2) dont l'axe principal est parallèle à une direction z, comprenant une partie d'insertion en forme de disque (3) qui est prévue, pour la fixation de la tête de sonde RMN (1), pour être poussé par en dessous contre un système de retenue (4) disposé sur la face inférieure de l'aimant RMN (2), qui est relié rigidement à l'aimant (2) et fait partie du dispositif de fixation, dans lequel une liaison mécanique fixe entre la tête de sonde (1) et la partie d'insertion (3) d'une part et entre la partie d'insertion (3) et le système de retenue (4) d'autre part peut être établie par une rotation de la partie d'insertion (3) autour de son axe de disque après que la tête de sonde RMN (1) a été poussée contre la face inférieure de la partie d'insertion (3) opposée au système de retenue (4) jusqu'à ce que l'extrémité supérieure de la tête de sonde (1) entre en contact avec l'extrémité supérieure du système de retenue (4), et dans lequel la partie d'insertion en forme de disque (3) est formée de telle sorte qu'en plus d'une coopération de formes, une liaison à force variable entre la tête de sonde (1) et le système de retenue (4) peut également être établie à l'aide d'au moins un élément élastique (8),

**caractérisé en ce**

**que** la tête de sonde (1) peut être fixée à la partie d'insertion (3) au moyen de plusieurs éléments de retenue rigides d'une seule pièce (6) de longueur fixe, qui font partie du dispositif de fixation,

**que** l'élément élastique ou les éléments élastiques (8) de la partie d'insertion (3) ainsi que les éléments de retenue (6) sont réalisés géométriquement de telle sorte que, dans un premier état ouvert, il existe une liaison avec un jeu mécanique de 0,5 mm à 5 mm entre la partie d'insertion (3), les éléments de retenue (6), l'élément élastique (8) ou les éléments de élastiques (6) étant détendu(s),

et **que**, dans un second état fermé, il existe une liaison sans jeu mécanique entre la partie d'insertion (3) et les éléments de retenue (6), l'élément élastique (8) ou les éléments élastiques (8) étant sous tension mécanique.

2. Dispositif de fixation selon la revendication 1, **caractérisé en ce que** l'élément élastique (8) ou les éléments élastiques (8) est/sont réalisé(s) de telle sorte que la force de retenue augmente de façon continue lorsque les éléments élastiques (6) sont actionnés et atteint son maximum dans la position finale dans le second état fermé.

3. Dispositif de fixation selon la revendication 1 ou 2, **caractérisé en ce qu'**une liaison sans jeu entre la tête de sonde (1) et le système de retenue (4) est formée avant même que la partie d'insertion (3) n'ait atteint sa position finale dans le second état fermé lors d'une rotation dans le sens de fermeture.

4. Dispositif de fixation selon l'une des revendications précédentes, **caractérisé en ce que** la partie d'insertion en forme de disque (3) est réalisée sous la forme d'un dispositif de montage rapide, de préférence d'une fermeture à baïonnette, qui peut en particulier tourner autour de l'axe de disque parallèlement à la direction z.

5. Dispositif de fixation selon l'une des revendications précédentes, **caractérisé en ce qu'**un dispositif de verrouillage (7) est prévu pour empêcher le desserrage involontaire d'une fixation.

6. Dispositif de fixation selon l'une des revendications précédentes, **caractérisé en ce que** la tête de sonde (1) peut être fixée à la partie d'insertion (3) au moyen de plusieurs, de préférence de deux éléments de retenue (6) opposés, en particulier des boulons de retenue, qui sont disposés sur un cercle de trous autour de l'axe de disque avec un diamètre compris entre 10 cm et 15 cm, et que les éléments de retenue (6) présentent une extension longitudinale radiale maximale dans le plan de disque de la partie d'insertion (3) comprise entre 5 mm et 10 mm, de préférence d'environ 8 mm.

7. Dispositif de fixation selon l'une des revendications précédentes, **caractérisé en ce que** la hauteur totale du dispositif de fixation complet parallèlement à l'axe de disque de la partie d'insertion (3) est comprise entre 7 mm et 15 mm, de préférence est d'environ 10 mm.

8. Dispositif de fixation selon l'une des revendications précédentes, **caractérisé en ce que** la partie d'insertion en forme de disque (3) comprend une coulisse à ressort en matériau non magnétique, de préférence en bronze à ressort.

9. Dispositif de fixation selon la revendication 8, **caractérisé en ce que** la coulisse à ressort est constitué d'une seule pièce.

10. Dispositif de fixation selon l'une des revendications précédentes, **caractérisé en ce qu'**une section de retenue (5), sur laquelle la partie d'insertion (3) peut être montée de manière réversible, est fixée de manière rigide sur la face inférieure du système de retenue (4) opposée à l'aimant.

11. Dispositif de fixation selon la revendication 10, **caractérisé en ce que** la section de retenue (5) entoure radialement la partie d'insertion (3) à la manière d'un boîtier à l'état monté.

12. Dispositif de fixation selon la revendication 10 ou 11, **caractérisé en ce qu'**un palier de glissement est prévu entre la section de retenue (5) et la partie d'insertion (3).

13. Dispositif de fixation selon la revendication 12, **caractérisé en ce que** les matériaux des partenaires de glissement du palier de glissement sont choisis de telle sorte que la force de manœuvre et l'abrasion soient réduites au minimum, de préférence en utilisant du PET-C et du bronze à ressort comme partenaires de glissement.

14. Dispositif de fixation selon l'une des revendications précédentes, **caractérisé en ce que** la combinaison du ou des éléments élastiques (8), de la longueur de la tête de sonde (1) et de la longueur du système de retenue (4) est conçue de telle sorte qu'une course élastique $f \geq 2$ mm soit déclenchée lorsque la partie d'insertion (3) est actionnée.

15. Dispositif de fixation selon l'une des revendications précédentes, **caractérisé en ce que** le système de retenue (4) est réalisé sous la forme d'un système de shim pour la mise en forme du champ magnétique homogène dans un spectromètre RMN.

EP 3 454 068 B1

Fig. 1a

Fig. 1b

12

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013204131 B3

- DE 102013212312 B4

**In der Beschreibung aufgeführte Nicht-Patentliteratur**

- Manual Probes. User Manual Version 003. *Bruker BioSpin AG aus dem,* September 2009